# EUROPEAN PATENT SPECIFICATION

(11) **EP 0 488 576 B1**
(45) Date of publication and mention of the grant of the patent: **20.08.1997**
(21) Application number: 91310679.5
(22) Date of filing: 20.11.1991
(51) Int. Cl.: H01L 21/60, H01L 23/522

(54) **Method of forming an integrated circuit contact**
Verfahren zur Herstellung eines Kontakts für integrierte Schaltungen
Procédé de formation d'un contact pour circuit intégré

(30) Priority: 29.11.1990 US 621142
(43) Date of publication of application: 03.06.1992
(73) Proprietor: AT&T Corp., New York, NY 10013-2412 (US)
(72) Inventor: Chittipeddi, Sailesh, Whitehall, Pennsylvania 1052 (US); Cochran, William Thomas, New Tripoli, Pennsylvania 18066 (US); Kelly, Michael James, Orefield, Pennsylvania 18069 (US)
(74) Representative: Johnston, Kenneth Graham

(56) References cited:
- DE-A- 3 930 655
- US-A- 4 450 041
- PATENT ABSTRACTS OF JAPAN, vol. 10, no. 46 (E-383) 22 February 1986; & JP-A-60 201 655
- APPLIED PHYSICS LETTERS, vol. 39, no. 1, July 1981, New York US, pp. 119-121; J.I. PANKOVE et al.: 'Bombardment-induced corrosion resistance of aluminum'

## Description

### Technical Field

The present invention relates to methods for forming conductive interconnections in semiconductor integrated circuits.

### Background of the Invention

Many modem integrated circuits utilize aluminum to interconnect devices. When aluminum is deposited in direct contact with a source or drain region, a subsequent thermal treatment often causes a problem termed "junction spiking." That is, the solubility of silicon in aluminum rises as temperature increases. Consequently, when a silicon substrate, such as a source or drain region, is in intimate contact with a pure aluminum film, the silicon substrate acts as a source of the silicon which the aluminum takes up in solution. In addition, the diffusivity of silicon in the aluminum film at temperatures above 400°C is quite high. Consequently, a significant quantity of silicon may move from the region below the metal-substrate interface and into the aluminum film. Simultaneously, aluminum from the film will move to fill the voids created by the departing silicon. If the penetration by the aluminum is deeper than the p-n junction depth, the junction may be electrically shorted (junction spiking). Various solutions to the problem have been posed in the past. For example, instead of pure aluminum, an alloy of aluminum which contains a concentration of silicon in excess of the silicon solubility at the maximum process temperature may be used in lieu of pure aluminum. Thus, when the aluminum-silicon interface is heated, the aluminum alloy film does not need to receive silicon into the solution from the substrate and junction spiking is avoided.

As junctions become shallower, metal lines become narrower, integrated circuit geometries shrink, and more elaborate contact structures have been employed. Frequently, barrier metals are deposited between the aluminum and the underlying silicon. Titanium tungsten, titanium nitride, various silicides, etc. have been employed as barrier metals.

However, as subsequent thermal processing of integrated circuit packages becomes more severe, the aluminum spiking problem has begun to reappear. New ceramic flat quad packaging often requires subsequent thermal processing at temperatures near 450°C due to glass flow temperature requirements. This elevated temperature frequently causes aluminum spiking through underlying barriers. Typically this problem is worse for shallower junctions. And since in most CMOS circuits then n-type junctions are shallower, they tend to spike more often than p-type junctions.

Pat.Abs.Jap.Vol.10 No. 46 (E-383) 22/2/86 and Jp-A-60201655 disclose semiconductor integrated circuits and methods of forming wirings to connect the semiconductor elements. The integrated circuit has a silicon substrate and the wiring is of multilayer construction.

DE-A-3930655 discloses a similar arrangement with contact metallizations with silicon containing layers and diffusion barriers.

US-A-4450041 discloses integrated circuits with a silicon substrate and layers of silicon dioxide and aluminum on the substrate.

According to the present invention, there is provided a method as defined in claim 1.

In an illustrative embodiment, the present invention alleviates the problem of junction spiking by providing a sacrificial source of silicon proximate to an aluminum layer. The sacrificial silicon source provides silicon for diffusion into the aluminum, without inducing diffusion of silicon from the junction substrate into the aluminum metal. Thus, the inventive method illustratively includes forming a dielectric layer upon a substrate; creating at least one opening in the dielectric layer; forming a layer of an aluminum-rich material within the opening; and forming a layer of silicon-rich material adjacent said layer of aluminum-rich material.

An alternative embodiment features implanting silicon into the aluminum-rich layer.

### Brief Description of the Drawing

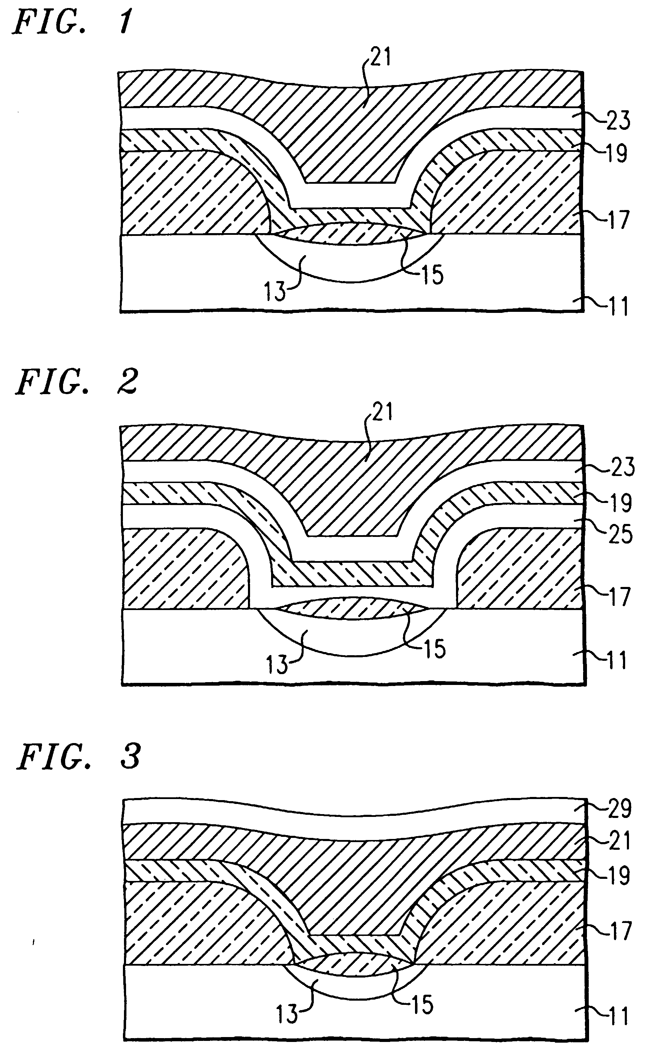

FIGs. 1-3 are views useful in understanding the present invention.

### Detailed Description

In FIG. 1, reference numeral 11 denotes a silicon, or epitaxial silicon substrate. In general, the term substrate is used herein to mean an element which supports other elements. Substrate 11 may be, for example, n or p type silicon. Reference numeral 13 denotes typically a source or drain region which is usually doped in an opposite manner to substrate 11. Reference numeral 17 denotes a dielectric layer covering substrate 11. Typically, dielectric 17 may be silicon dioxide and may be formed from a variety of chemical precursors, if desired. Reference numeral 15 denotes a silicide formed over region 13. Typically, silicide 15 may be titanium silicide, tantalum silicide, tungsten silicide, or platinum silicide. Layer 19 formed over silicide 15 may typically be a layer of titanium tungsten or titanium nitride or some combination of silicide and nitride or other barrier material (especially if silicide 15 is titanium silicide).

Reference numeral 21 denotes an aluminum layer. Layer 21 may be an aluminum-rich material, i.e., aluminum having copper or silicon or both or aluminum having other material incorporated. It is desired that electrical contact be formed between aluminum layer 21 and underlying region 15. However, applicants have found that modern packaging techniques requiring post-device formation high-temperature processing often induce spiking between aluminum layer 21 and region 13 despite the presence of silicide layer 15 and protective barrier layer 19. Therefore, in accordance with one embodiment of the invention, layer 23, a layer of amorphous silicon (or silicon-rich material, not forming part of the claimed invention), is deposited upon layer 19 before the deposition of aluminum layer 21. Should subsequent high-temperature processing tend to induce spiking, layer 23 serves as a sacrificial layer and interdiffuses with layer 21, thus helping to prevent involvement of region 13 with the spiking phenomenon.

Typically, layer 19, may be 600 Å (10Å = 1nm) of rapid thermally nitrided (titanium nitride) titanium, while layer 23 may be approximately 120 Å of amorphous silicon (usually doped with boron).

A processing sequence for forming the structure of FIG. 1 involves: (after an opening is made in dielectric 17), exposing silicide 15, then forming a rapid thermally nitrided titanium layer 19, followed by silicon layer 23. Then aluminum layer 21 is deposited and may subsequently be patterned to form runners.

FIG. 2 illustrates an embodiment useful in understanding the present invention. In FIG. 2, similar reference numerals refer to similar components throughout. It will be noted that in FIG. 2, unlike FIG. 1, an additional silicon layer 25 is deposited prior to barrier layer 19. Layer 25 provides additional silicon should barrier layer 23 prove insufficient (and some spiking occur through layer 19). (Layer 23 may even be omitted, if desired, and layer 25 alone employed to provide any needed silicon not forming part of the claimed invention.) Silicide 15 may be formed, if desired, first by a self-aligned (salicide) process.

It should be noted in connection with FIGs. 1 and 2 that, although silicide region 15 provides additional protection against spiking and improves electrical contact, it is not essential to the practice of the present invention.

FIG. 3 illustrates another embodiment useful in understanding the present invention. In FIG. 3 after silicide region 15 is formed, barrier layer 19 is formed. Then aluminum layer 21 is deposited in contact with layer 19. Layer 19 is, as before, approximately 600 Å of rapid thermally nitrided titanium.

At this point it should be noted that it is frequently customary to deposit an anti-reflective coating (ARC) upon aluminum layers so that subsequent patterning may be made simpler. Typically, ARCs are made from silicon. In FIG. 3, reference numeral 29 denotes a silicon ARC layer deposited upon aluminum layer 21. In general practice, after aluminum layer 21 is patterned, the remaining portions of ARC 29 are removed. However, applicants have found that permitting ARC 29 to remain in place after patterning also provides a source of silicon helpful in avoiding the silicon spiking problem.

In general, it has been found that the desirable thickness for the sacrificial silicon layer is approximately 12x10⁻⁹m (120 Å) (i.e. 1.7% by weight for 5x10⁻⁷m (5000 Å) metal). Although FIGs. 1,2, and 3 show the presence of a barrier layer such as layer 19 between the sacrificial silicon layer and the aluminum layer, the sacrificial silicon layer is still, nevertheless quite helpful in preventing spiking.

In general, the method useful in understanding the invention may be practiced with or without a barrier layer such as layer 19. And the invention may be practiced regardless of the initial silicon content of the aluminum. Generally, it is desirable to provide a silicon layer which has enough silicon to satisfy the solid solubility limit of the aluminum.

An alternative embodiment useful in understanding the present invention involves the implantation of the aluminum with silicon (with or without the sacrificial silicon layer). In this embodiment, after the aluminum has been deposited and patterned, the window mask may or may not be used again, and a silicon ion implantation at approximately 1E15-1E16 dosage and 10 Kev-110 Kev. into the aluminum is performed. The implanted silicon helps prevent spiking. The implantation technique may be used in addition to, or instead of, the sacrificial silicon layers.

Another embodiment features a silicon ion implantation into a barrier layer, such as layer 19, before aluminum layer formation. The silicon may be implanted at 1E15-1E16 and 10 Kev-110 Kev. The silicon ions in the barrier layer may later be absorbed into the aluminum, thus preventing spiking. This embodiment may be practiced with or without a separately formed silicon sacrificial layer.

The implantation techniques thus produce an aluminum layer with an interdiffused silicon layer. A similar structure obtains after the aforementioned ARC interdiffuses with the aluminum layer.

## Claims

1. A method of fabricating an integrated circuit upon a substrate (11) comprising the following steps in the given order :
forming a dielectric layer (17) upon a silicon substrate (11);
creating at least one opening in said dielectric layer (17);
forming a first layer of silicon (25) within said opening;
forming a barrier layer (19);
forming a second layer of silicon (23); and
forming a layer of aluminum (21) within said opening.

2. The method of claim 1 in which said barrier layer (19) is chosen from the group consisting of titanium tungsten and titanium nitride.

3. The method of claim 1 in which a silicide (15) is formed upon said substrate (11) prior to formation of said second silicon layer (23).

4. The method of claim 1 in which a third layer (29) of silicon material is formed after said aluminum layer (21).

5. The method of claim 4 wherein said third layer (29) is formed by ion implantation of silicon into an aluminum layer (21).

6. The method of claim 5 in which said implantation step is performed through a window mask.

7. The method of claim 6 in which said implant dose is approximately 1E15-1E16/cm².

8. The method of claim 7 in which said implant energy ranges from 10 Kev. to 110 Kev.

## Patentansprüche

1. Verfahren zur Herstellung einer integrierten Schaltung auf einem Substrat (11) mit den folgenden Schritten in der angegebenen Reihenfolge:
der Bildung einer Dielektrikumsschicht (17) auf einem Siliciumsubstrat (11);
der Schaffung mindestens einer Öffnung in der Dielektrikumsschicht (17);
der Bildung einer ersten Schicht aus Silicium (25) innerhalb der Öffnung;
der Bildung einer Sperrschicht (19);
der Bildung einer zweiten Schicht aus Silicium (23); sowie
der Bildung einer Schicht aus Aluminium (21) innerhalb der Öffnung.

2. Verfahren nach Anspruch 1, bei dem die Sperrschicht (19) aus der Reihe Titan, Wolfram und Titannitrid gewählt wird.

3. Verfahren nach Anspruch 1, bei dem auf dem Substrat (11) vor der Bildung der zweiten Siliciumschicht (23) ein Silicid (15) gebildet wird.

4. Verfahren nach Anspruch 1, bei dem nach der Aluminiumschicht (21) eine dritte Schicht (29) aus Siliciummaterial gebildet wird.

5. Verfahren nach Anspruch 4, bei dem die dritte Schicht (29) durch Ionenimplantation von Silicium in eine Aluminiumschicht (21) gebildet wird.

6. Verfahren nach Anspruch 5, bei dem der Implantationsschritt durch eine Fenstermaske hindurch erfolgt.

7. Verfahren nach Anspruch 6, bei dem die Implantatsdosis etwa 1E15-1E16/cm² beträgt.

8. Verfahren nach Anspruch 7, bei der die Implantatsenergie im Bereich von 10 Kev. bis 110 Kev. liegt.

## Revendications

1. Procédé de fabrication d'un circuit intégré sur un substrat (11) comprenant les étapes suivantes, dans l'ordre donné:
former une couche diélectrique (17) sur un substrat de silicium (11);
créer au moins une ouverture dans ladite couche diélectrique (17);
former une première couche de silicium (25) dans ladite ouverture;
former une couche de barrière (19);
former une deuxième couche de silicium (23); et
former une couche d'aluminium (21) dans ladite ouverture.

2. Procédé selon la revendication 1, dans lequel ladite couche de barrière (19) est choisie dans le groupe constitué par le tungstène au titane et le nitrure de titane.

3. Procédé selon la revendication 1, dans lequel un siliciure (15) est formé sur ledit substrat (11) avant la formation de ladite deuxième couche de silicium (23).

4. Procédé selon la revendication 1, dans lequel une troisième couche (29) de matière au silicium est formée après ladite couche d'aluminium (21).

5. Procédé selon la revendication 4, dans lequel ladite troisième couche (29) est formée par implantation ionique de silicium dans une couche d'aluminium (21).

6. Procédé selon la revendication 5, dans lequel ladite étape d'implantation est réalisée par un masque à fenêtre.

7. Procédé selon la revendication 6, dans lequel ladite dose d'implantation est d'environ 1E15-1E16/cm².

8. Procédé selon la revendication 7, dans lequel ladite énergie d'implantation s'échelonne de 10 keV à 110 keV.
